# FASCICULE DE BREVET EUROPEEN

(11) **EP 0 462 034 B1**
(45) Date de publication et mention de la délivrance du brevet: **13.03.1996**
(21) Numéro de dépôt: 91420192.6
(22) Date de dépôt: 13.06.1991
(51) Int. Cl.: H03K 17/08

(54) **Dispositif de protection pour relais statique à semi-conducteurs**
Schutzvorrichtung für statisches Halbleiterrelais
Protecting device for semiconductor static relay

(30) Priorité: 13.06.1990 FR 9007605
(43) Date de publication de la demande: 18.12.1991
(73) Titulaire: FERRAZ Société Anonyme, F-69003 Lyon (FR)
(72) Inventeur: de Palma, Jian Franco, F-73390 Chateauneuf (FR); Rousseau, Jean-Jacques, F-42100 Saint Etienne (FR); Epron, Pierre, F-69008 Lyon (FR)
(74) Mandataire: Monnier, Guy

(56) Documents cités:
- GB-A- 1 042 550
- ELEKTRONIK, vol. 34, no. 19, 20 septembre 1985, pages 119-127; H. HINTZ: "Triacs: Aufbau - Eigenschaften - Anwendungen"
- REVUE DE PHYSIQUE APPLIQUEE, vol. 24, no. 2, février 1989, pages 195-205; F. FOREST et al.: "Evolution des principes de la commutation assistée dans les onduleurs de tension. Présentation d'un onduleur haute fréquence à "commutations douces""
- REVUE GENERALE DE L'ELECTRICITE, vol. 75, no. 7/8, juillet/août 1966, pages 939-949, Paris, FR; J. LECORGUILLIER: "Les gradateurs tête-bêche en débit sur circuit inductif"

## Description

La présente invention se rapporte à un dispositif de protection contre les surcharges de fonctionnement à l'ouverture pour relais statiques à semi-conducteurs.

Il est connu de protéger les interrupteurs commandables de puissance à semi-conducteurs (thyristors, transistors bipolaires, transistors à effet de champ,...) contre les surtensions et les vitesses de variation de la tension qui apparaissent nécéssairement aux bornes du composant à l'ouverture de celui-ci. Il est en conséquence prévu, aux bornes de cet interrupteur statique de puissance, un circuit de protection constitué généralement par la mise en parallèle d'un parasurtenseur de type varistance et d'un réseau Résistance-Condensateur-Diode (ou d'une partie de ce réseau comportant au minimum le condensateur).

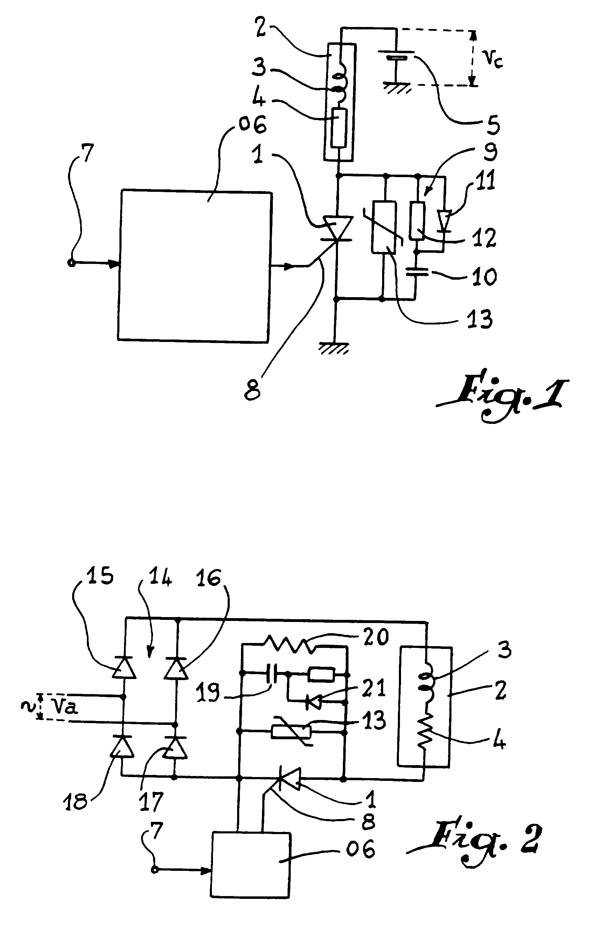

Une illustration de cette technique connue est donnée, à titre d'exemple, sur les fig. 1 à 3 jointes.

Le schéma connu le plus simple est représenté en fig. 1. Il s'agit alors d'un interrupteur statique constitué d'un thyristor 1 qui est placé en série avec une charge 2, à self-induction 3 et résistance 4 propres, elle-même alimentée par une source 5 de tension continue Vc.

Ce thyristor 1 est, dans cet exemple, un thyristor "GTO", c'est-à-dire un thyristor blocable par la gâchette, qui est classiquement commandé, sur sa gachette 8, en allumage et extinction par un circuit de commande 06 recevant de l'extérieur des impulsions de basculement sur son entrée 7.

Ce thyristor 1 est protégé :
- contre les vitesses de variation de la tension à l'ouverture par un circuit "SNUBBER" 9 comportant, de manière classique, un condensateur par exemple polypropylène 10, alimenté à travers une diode en direct 11 aux bornes de laquelle est branchée une résistance 12 servant à la décharge du condensateur 10 ; et
- contre les surtensions à l'ouverture par une varistance 13, ou autre type de parasurtenseur, qui limite la valeur de la tension aux bornes du thyristor 1 tout en absorbant la majeure partie de l'extracourant de rupture dû à la self 3.

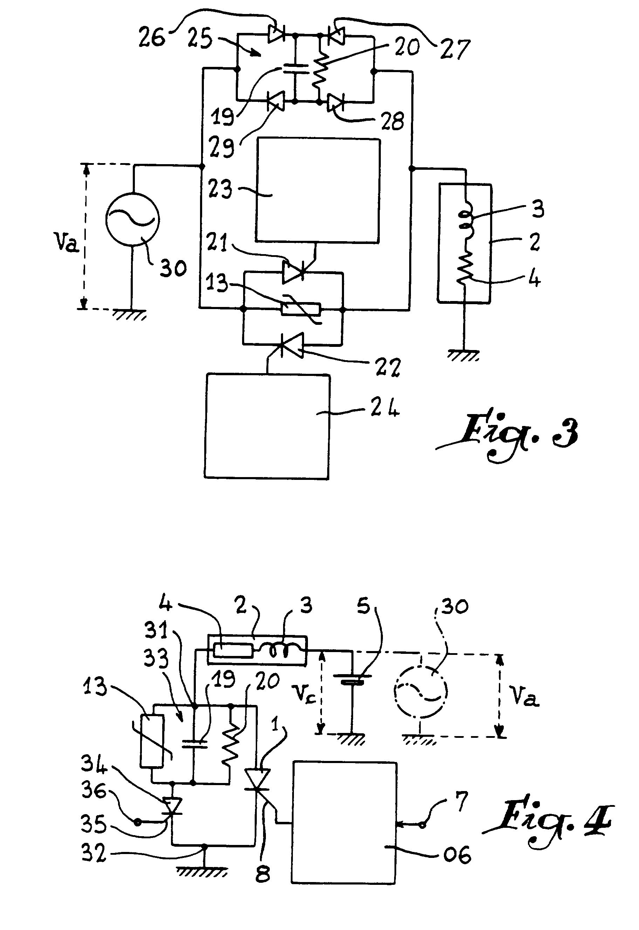

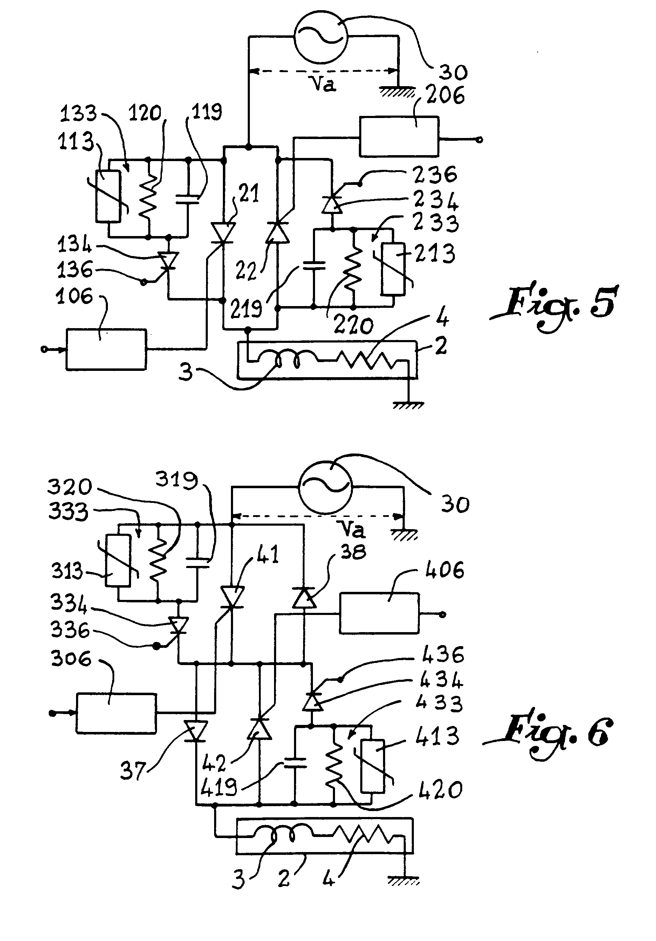

S'il s'agit maintenant de commuter une charge 2 alimentée en tension alternative Va, deux cas se présentent classiquement :
- Ou bien (voir fig. 2) le relais statique, c'est-à-dire dans cet exemple le thyristor "GTO" 1, est un composant asymétrique (c'est-à-dire ne pouvant pas supporter l'application d'une tension inverse à ses deux bornes), et dans ce cas il doit être alimenté à travers un redresseur (dans cet exemple à travers un pont redresseur 14 à quatre diodes 15 à 18). On prévoit là encore la varistance 13 aux bornes du thyristor 1, ainsi qu'un condensateur 19 alimenté à travers une diode en direct 21 aux bornes de laquelle est branchée une résistance 20 servant à la décharge du co-densateur 19.
- Ou bien (fig. 3), il est fait usage de relais statiques dits "symétriques" (c'est-à-dire aptes à supporter une tension inverse), et il est alors classiquement fait usage d'un montage parallèle de deux thyristors tête-bêche 21, 22 branchés en série avec la source alternative 30 à tension Va et la charge 2. Chaque thyristor 21, 22 est associé à un circuit de commande de gâchette, respectivement 23 et 24, et la protection contre la surtension à l'ouverture est toujours assurée par la varistance 13, branchée aux bornes des thyristors 21 et 22. Il est là aussi prévu un condensateur 19, avec résistance de décharge 20, pour absorber les vitesses de variation de la tension à l'ouverture soit du thyristor 21, soit du thyristor 22. a diode 11 précédente n'est alors pas indispensable, puisque déjà incluse dans un pont 25. Cependant, cet ensemble 19, 20 est branché dans la diagonale du pont redresseur 25, à diodes 26 à 29, car il ne serait pas possible d'appliquer une tension alternative au condensateur 19 sans y créer un important courant de fuite totalement préjudiciable au fonctionnement de l'installation.

Ces dispositifs connus présentent les inconvénients suivants :
- Lorsque le relais statique, tel que le thyristor 1 en fig. 1, est ouvert, la varistance 13 qui est branchée à ses bornes est soumise continuellement à toute la tension d'alimentation. Afin d'éviter un vieillissement accéléré du parasurtenseur, la tension de veille de celui-ci doit être dimensionnée à des valeurs telles que le courant le traversant sous cette tension n'engendre pas une forte dissipation dans le parasurtenseur. Cette solution conduit à un surdimensionnement de la tension de veille et à la nécessité d'augmenter la tension maximale admissible de l'interrupteur commandable, et donc, de choisir des interrupteurs commandables surdimensionnés, en conséquence plus onéreux.
- Le dimensionnement en tension de ce parasurtenseur est lié à la tension d'utilisation de l'interrupteur commandable, à la tension maximale admissible par cet interrupteur commandable, et à la caractéristique de limitation du parasurtenseur. Ceci conduit à un fort surdimensionnement de la tenue en tension des composants commutables : sur un réseau alternatif 220/380 volts, on doit utiliser des composants commandables dont la tension de tenue est comprise entre 1200 et 1400 volts. S'agissant d'un réseau alternatif 660 volts, les composants à prévoir doivent tenir environ 2000 volts, et il faut faire alors appel à des composants onéreux.
- Dans le cas d'alimentation en tension alternative, il est nécessaire, comme on l'a vu précédemment en référence à fig. 2 et 3, de prévoir un pont redresseur, au moins afin d'éviter que le condensateur utilisé 19 ne soit alimenté en alternatif, ce qui entraînerait un important et préjudiciable courant de fuite.
- La puissance dissipée par l'interrupteur commandable utilisé sur un réseau alternatif et constitué de composant(s) ayant des tensions de tenue non symétriques est importante. Elle peut atteindre 300 watts pour 100 ampères-efficaces traversant l'interrupteur commandable.

L'invention vise à remédier à ces inconvénients. Elle se rapporte à un dispositif de protection contre les surcharges de fonctionnement à l'ouverture pour relais statique à semi-conduteurs, ce relais statique comportant au moins un interrupteur commandable, par exemple du genre thyristor GTO, transistor IGBT, transistor bipolaire, transistor à effet de champ..., et ce dispositif de protection comportant d'une part au moins un parasurtenseur, par exemple du genre varistance, apte à protéger ce relais statique contre les surtensions à l'ouverture et comportant au moins d'autre part un condensateur apte à protéger ce même relais statique contre les vitesses de variation de la tension à l'ouverture. Ce dispositif est caractérisé en ce que ce condensateur et ce parasurtenseur forment au moins une partie d'un circuit parallèle dont une première borne est reliée à une des deux bornes de puissance de l'interrupteur commandable, et dont l'autre borne est reliée à l'autre borne de puissance de cet interrupteur à travers un relais statique auxiliaire qui est commandé à la fermeture au moins dès le début et au moins pendant la majeure partie de la durée de la phase d'ouverture de cet interrupteur commandable.

Avantageusement, ce relais statique auxiliaire peut être constitué d'au moins un thyristor de type ordinaire (c'est-à-dire non blocable par la gâchette) qui est commandé à la fermeture soit simultanément à la commande d'ouverture de cet interrupteur commandable, soit légèrement avant, et qui s'éteint ensuite de lui-même, par annulation naturelle du courant qui le traverse, en fin de phase d'ouverture de l'interrupteur commandable.

De toute façon, l'invention sera bien comprise, et ses avantages et autres caractéristiques ressortiront, lors de la description suivante de trois exemples non limitatifs de réalisation, en référence au dessin schématique annexé dans lequel :
Les fig. 1 à 3 correspondent à la technique antérieure discutée ci-dessus.
Fig. 4 est un schéma électrique d'un mode de réalisation du dispositif suivant l'invention pour relais statique à un seul thyristor GTO branché en série avec une charge alimentée en tension continue ou alternative ;
Fig. 5 montre de même façon un mode de réalisation pour relais statique à deux thyristors GTO symétriques, ce relais statique étant branché en série avec une charge alimentée en tension alternative ; et
Fig. 6 montre un montage voisin de celui de fig. 5, mais utilisant deux thyristors GTO asymétriques.

Fig. 4 illustre l'adaptation de l'invention au dispositif classique décrit précédemment en référence à fig. 1. On retrouve en particulier :
- la source d'alimentation continue de puissance 5 fournissant la tension Vc ;
- la charge 2, avec sa self-inductance 3 et sa résistance 4 ;
- et le thyristor GTO 8 (avec son circuit de commande 06) qui est branché en série avec cette charge.

Conformément à l'invention, un circuit particulier est branché aux bornes 31, 32 du thyristor 1, ce circuit comprenant :
- un circuit de protection 33 constitué classiquement par la mise en parallèle d'une varistance 13 (identique à celles de fig. 1 à 3), d'un condensateur par exemple polypropylène 19 (identique aux condensateurs 19 des fig. 2 et 3), et d'une résistance de décharge 20 (identique aux résistances 20) ;
- et un thyristor auxiliaire 34, branché en série avec le circuit parallèle 33.

Ce thyristor auxiliaire 34 est ici un thyristor ordinaire ou de type GTO sa gâchette 35 est commandée en 36 par des impulsions d'allumage qui sont en pratique synchrones des impulsions d'extinction du thyristor GTO 1 appliquées en 7 au circuit 06. L'essentiel, pour le mise en oeuvre de l'invention, étant que le thyristor 34 soit passant lorsque le thyristor 1 commence à se bloquer, il est suffisant que l'impulsion d'allumage de thyristor 34 soit appliquée en même temps ou légèrement après la commande d'extinction du thyristor 1 : compte-tenu du léger retard dû en particulier au circuit 06, et au temps de désaturation du thyristor 1, le thyristor 34 est déjà allumé lorsque l'impulsion de blocage commence à agir en 8.

Le fonctionnement du dispositif de fig. 4 est le suivant :

Lorsque l'on désire couper l'alimentation de la charge 2, c'est-à-dire ouvrir le relais statique 1, une impulsion de blocage est appliquée en 7, tandis que simultanément une impulsion d'allumage du thyristor auxiliaire 34 est appliquée en 36. Compte-tenu du retard dû en temps de désaturation du thyristor GTO 1, le thyristor 34 est allumé avant que l'impulsion de blocage n'agisse sur la gâchette 8 du thyristor GTO 1. Le circuit de protection classique 33 est alors branché aux bornes du thyristor 1, et il joue pleinement son rôle pendant toute la phase d'extinction de ce thyristor. Le thyristor 34 s'éteint alors naturellement lorsque la tension aux bornes du dispositif 33 atteint la valeur Vc de la tension d'alimentation, puisque le courant qui traverse ce thyristor atteint à ce moment la valeur zéro. Le thyristor 34 étant alors ouvert, la varistance 13 n'a plus aucune tension à ses bornes (en première approximation, le courant de fuite du thyristor 34 est ici supposé nul), ce qui limite considérablement son veillissement par rapport aux dispositifs de l'art antérieur.

Si maintenant, comme indiqué en traits mixtes en fig. 4, on imagine les thyristors (supposés symétriques) soumis à une tension alternative Va (générateur 30 au lieu de l'alimentation continue 5), le schéma obtenu devient l'adaptation à l'invention du circuit de fig. 2. On constate que le précédent pont redresseur 14 n'est plus nécessaire puisqu'en ce qui concerne l'alimentation redressée du condensateur 19, le thyristor 34 joue parfaitement ce rôle redresseur en plus de sa fonction précédemment décrite.

S'agissant cependant d'une alimentation alternative, on préfèrera bien entendu utiliser un relais statique double-alternance, du genre par exemple de celui décrit précédemment en référence à fig. 3.

S'agissant d'un relais à thyristors symétriques, on utilisera donc, à l'instar de fig. 3, un montage parallèle et tête-bêche. Une telle utilisation, adaptée selon l'invention, est représentée en fig. 5.

Ce schéma utilise donc les deux mêmes thyristors GTO 21 et 22 qu'en fig. 3, mais chacun de ces thyristors est associé à un circuit de protection, avec thyristor auxiliaire, identique à celui décrit en référence à fig. 4 et fonctionnant de même façon :
- au thyristor 21 est associé un thyristor auxiliaire 134 (identique à 34) en série avec un circuit de protection 133 (identique à 33) ;
- et au thyristor 22 est, d'exactement même façon, associé le thyristor auxiliaire 234 en série avec le circuit de protection 233.

C'est à dessein que les éléments relatifs aux thyristors 21 et 22 ont été en fig. 5 désignés par les mêmes chiffres de référence que ceux relatifs, en fig. 4, au thyristor 1, mais respectivement précédés d'un "1 " et d'un "2" .

Il n'empêche néanmoins que l'on préfère souvent utiliser, même sous tension alternative, des thyristors asymétriques, qui présentent en pratique de bien meilleures qualités que les thyristors symétriques.

De tels thyristors ne doivent pas être soumis à des tensions inverses et, à ce sujet, fig. 6 montre un mode de réalisation conforme à l'invention, utilisant deux thyristors GTO 41 et 42 branchés en série et en sens inverses dans un demi-pont de diodes redresseuses 37 et 38. Pour l'alternance positive le thyristor 42 (alors seul en inverse) est court-circuité par la diode 37, tandis que pour l'alternance négative, le thyristor 41 (alors seul en inverse) est court-circuité par la diode 38.

Pour le reste, ces deux thyristors 41 et 42 fonctionnent, toujours selon la présente invention, exactement de la même façon que le thyristor 1 de fig. 4 et que les deux thyristors 21 et 22 de fig. 5, et c'est à nouveau pour bien mettre en relief cette similitude de fonctionnement que les éléments, conformes à l'invention et totalement identiques à ceux de fig. 4, ont été désignés en fig. 6 par les mêmes chiffres de référence, respectivement précédés d'un "3" pour ceux associés au thyristor 41 et d'un "4" pour ceux associés au thyristor 42.

Le demi-pont à diodes 37, 38 qui est utilisé pour ce montage selon fig. 6 permet de minimiser avantageusement la chute de tension aux bornes de l'interrupteur commandable et donc sa puissance dissipée, qui est alors de l'ordre de 250 watts pour 100 ampères-efficaces traversant cet interrupteur commandable.

Il va de soi que le ou les interrupteurs commandables "principaux" peuvent être formés par d'autres composants que des thyristors GTO, tels que : transistors IGBT, transistors bipolaires, transistors à effet de champ,... De même façon, le ou les interrupteurs "auxiliaires" peuvent être autres que des thyristors, ordinaires : thyristors GTO, transistors IGBT, transistors bipolaires, transistors à effet de champ... De même encore, le ou les parasurtenseurs peuvent être constitués par d'autres éléments limiteurs que des varistances : diodes Zener, associations de composants à varistance-éclateur, etc...

## Revendications

1. Dispositif de protection contre les surcharges de fonctionnement à l'ouverture pour relais statique à semi-conducteurs, ce relais statique comportant au moins un interrupteur commandable (1), le dispositif de protection comportant d'une part au moins un parasurtenseur (13) apte à protéger ce relais statique contre les surtensions à l'ouverture et comportant au moins d'autre part un condensateur (19) apte à protéger ce même relais statique contre des vitesses excessives de variation de la tension à l'ouverture, caractérisé en ce que ce condensateur (19) et ce parasurtenseur (13) forment au moins deux branches d'un circuit parallèle (33) dont une première borne (31) est reliée à une des bornes de puissance de cet interrupteur commandable (1), et dont l'autre borne est reliée à l'autre borne de puissance (32) de cet interrupteur à travers un relais statique auxiliaire (34) qui est commandé à la fermeture au moins dès le début et au moins pendant la majeure partie de la durée de la phase d'ouverture de cet interrupteur commandable (1).

2. Dispositif selon la revendication 1, caractérisé en ce que ce relais statique auxiliaire est constitué d'au moins un thyristor (34), qui est commandé à la fermeture soit simultanément à la commande d'ouverture de cet interrupteur commandable (1), soit légèrement après, et qui s'éteint ensuite de lui-même, par annulation naturelle du courant qui le traverse, en fin de phase d'ouverture de l'interrupteur commandable (1).

3. Dispositif selon l'une quelconque des revendications 1 et 2, dans lequel le relais statique est alimenté en tension alternative (Va), en utilisant de ce fait au moins deux interrupteurs commandables (41, 42) de type asymétrique montés en série et en sens inverses, caractérisé en ce que chacun de ces interrupteurs commandables (41, 42) est respectivement associé à un montage série d'un circuit parallèle de protection (333, 433) et d'un relais statique auxiliaire (334, 434) commandé à la fermeture lorsque l'interrupteur commandable (41, 42) qui lui correspond est commandé à l'ouverture, et en ce que ces deux interrupteurs commandables asymétriques (41, 42) sont placés dans un demi-pont de diodes redresseuses (37, 38) aptes à courtcircuiter, à chaque alternance de la tension d'alimentation (Va), l'interrupteur commandable asymétrique (41, 42) qui serait sinon soumis à une tension inverse pendant cette alternance.

4. Dispositif selon l'une quelconque des revendications 1 et 2, dans lequel le relais statique est alimenté en tension alternative (Va), en utilisant de ce fait au moins deux interrupteurs commandables (21, 22) de type symétrique montés en parallèle et tête-bêche, caractérisé en ce que chacun de ces interrupteurs commandables (21, 22) est respectivement associé à un montage série d'un circuit parallèle de protection (133, 233) et d'un relais statique auxiliaire (134, 234) commandé à la fermeture lorsque l'interrupteur commandable (21, 22) qui lui correspond est commandé à l'ouverture.

## Patentansprüche

1. Schutzvorrichtung gegen beim Öffnen eines statischen Halbleiterrelais auftretende Überspannungen, wobei dieses statische Relais wenigstens einen Steuerschalter (1) aufweist, und die Schutzvorrichtung einerseits wenigstens einen Überspannungsableiter (13), bestimmt zur Sicherung des statischen Relais gegen Überspannungen beim Öffnen des Relais und andererseits wenigstens einen Kondensator (19), bestimmt zur Sicherung des statischen Relais gegen übermäßige schnelle Spannungsänderung beim Öffnen, **dadurch gekennzeichnet,** daß Kondensator (19) und Überspannungsableiter (13) in wenigstens zwei Zweige einer Parallel-Schaltung (33) angeordnet sind, deren erster Anschlußpunkt (31) mit einem der Leistungs-Anschlußpole des Steuerschalters (1) verbunden ist, und deren anderer Anschlußpunkt mit dem anderen Leistungs-Anchlußpol (32) besagten Steuerschalters (1) über ein statisches Hilfsrelais (34) verbunden ist, welches auf Schließen gesteuert wird, zumindest unverzüglich und zumindest für eine längere Dauer der Öffnungsphase des Steuerschalters (1).

2. Schutzvorrichtung nach Anspruch 1, **dadurch gekennzeichnet,** daß das statische Hilfsrelais wenigstens von einen Thyristor (34) gebildet ist, der derart gesteuert wird, daß er entweder gleichzeitig zum Öffnen des Steuerschalters (1) gesperrt wird, oder leicht danach, und der durch den bis zum Ende der Öffnungs-Phase des Steuerschalters (1) sich natürlicherweise ergebenen Abfall des durchfließenden Stromes, selbst löscht.

3. Schutzvorrichtung nach einem der Ansprüche 1 und 2, bei der das statische Relais mit einer Wechselspannung (Va) gespeist ist, unter Verwendung von wenigstens zwei Steuerschaltern (41, 42) asymmetrischen Typs, die entgegengesetzt in Serie geschaltet sind, **dadurch gekennzeichnet,** daß jeder der Steuerschalter (41, 42) in Serienschaltung mit einem parallel geschalteten Schutzkreis (333, 433) und einem statischen Hilfsrelais (334, 434), gesteuert auf Schließen, wenn besagter, dazu korrespondierender Steuerschalter (41, 42) auf Öffenen gesteuert ist, und dadurch daß die beiden asymmetrischen Steuerschalter (41, 42) in eine Halbbrücke von Gleichrichterdioden (37, 38) geschaltet sind, dazu bestimmt, bei jedem Wechsel der Speisespannung (Va) den asymmetrischen Steuerschalter (41, 42) abzuschalten, der anderenfalls einer Spannungs-Umkehr während des Wechsels unterworfen sein würde.

4. Schutzvorrichtung nach einem der Ansprüche 1 und 2, bei der das statische Relais mit einer Wechselspannung (Va) gespeist ist, unter Verwendung von wenigstens zwei Steuerschaltern (21, 22) symmetrischen Typs, die in Parallel-schaltung umgekehrt angeordnet geschaltet sind, **dadurch gekennzeichnet,** daß jeder der Steuerschalter (21, 22) beidseits verbunden mit einer Serienschaltung eines parallelen Sicherungkreises (133, 233) und einem statischen Hilfsrelais (134, 234) ist, gesteuert zum Schließen, wenn der der damit korrespondierende Steuerschalter (21, 22) auf Öffnen geschaltet ist.

## Claims

1. A device for protection against operating overloads upon opening for a static semiconductor relay, this static relay comprising at least one controllable switch (1), the protective device comprising on one hand at least one surge arrester (13) suitable for protecting this static relay against the excess voltages upon opening and comprising at least on the other hand one capacitor (19) suitable for protecting said static relay against excessive speeds of variation of the voltage upon opening, characterised in that this capacitor (19) and this surge arrester (13) form at least two branches of a parallel circuit (33), a first terminal (31) of which is connected to one of the power terminals of this controllable switch (1), and the other terminal of which is connected to the other power terminal (32) of this switch via an auxiliary static relay (34) which is controlled upon closing at least from the start and at least over the major part of the duration of the opening phase of this controllable switch (1).

2. A device according to Claim 1, characterised in that this auxiliary static relay is formed of at least one thyristor (34), which is controlled upon closing either simultaneously with the opening command of this controllable switch (1) or slightly thereafter, and which then switches off by itself, by natural turn-off of the current which passes therethrough, at the end of the opening phase of the controllable switch (1).

3. A device according to any one of Claims 1 and 2, in which the static relay is fed with alternating voltage (Va), thus using at least two controllable switches (41, 42) of asymmetrical type mounted in series and in opposite directions, characterised in that each of these controllable switches (41, 42) is respectively associated with series mounting of a parallel protective circuit (333, 433) and of an auxiliary static relay (334, 434) controlled upon closing when the controllable switch (41, 42) which corresponds thereto is controlled upon opening, and in that these two asymmetrical controllable switches (41, 42) are placed in a half-bridge of rectifier diodes (37, 38) suitable for short-circuiting, upon each alternation of the supply voltage (Va), the asymmetrical controllable switch (41, 42) which would otherwise be subjected to a reverse voltage during this alternation.

4. A device according to any one of Claims 1 and 2, in which the static relay is fed with alternating voltage (Va), thus using at least two controllable switches (21, 22) of symmetrical type mounted in parallel and head-to-tail, characterised in that each of these controllable switches (21, 22) is respectively associated with series mounting of a parallel protective circuit (133, 233) and of an auxiliary static relay (134, 234) controlled upon closing when the controllable switch (21, 22) which corresponds thereto is controlled upon opening.
